# EUROPÄISCHE PATENTANMELDUNG

(11) **EP 4 151 973 A1**
(43) Veröffentlichungstag der Anmeldung: **22.03.2023**
(21) Anmeldenummer: 22193660.2
(22) Anmeldetag: 02.09.2022
(51) Int. Cl.: G01L 5/00, H01R 13/187, H01R 13/631, G02B 6/38, G01M 5/00

(54) **VORRICHTUNG ZUR PRÜFUNG MINDESTENS EINES STECKELEMENTS**

(30) Priorität: 20.09.2021 EP 21197789
(71) Anmelder: Kistler Holding AG, 8408 Winterthur (CH)
(72) Erfinder: Buck, Reinhold, 8308 Illnau (CH); Konic, Davorin, 8115 Hüttikon (CH); Dudler, Patrick, 9425 Thal/SG (CH); Giger, Martin, 8400 Winterthur (CH)

(57) **Zusammenfassung**

Die Erfindung betrifft eine Vorrichtung zur Prüfung von mindestens einem Steckelement, mit einem Prüfelement, welches zur Prüfung in das Steckelement steckbar ist; mit einer Steckelementaufnahme in welcher ein Steckelement (2) angeordnet ist; mit einer Prüfelementaufnahme in welcher das Prüfelement angeordnet ist; wobei die Steckelementaufnahme und die Prüfelementaufnahme entlang einer Prüfachse für das Stecken beweglich angeordnet sind; mit einem Kraftsensor, welcher eingerichtet ist eine Kraft beim Stecken entlang der Prüfachse zu ermitteln und als ein Kraftsignal bereitzustellen; wobei die Vorrichtung ein Ausgleichselement zum Ausgleich eines Versatzes zwischen Steckelement und Prüfelement aufweist; wobei das Ausgleichselement in mindestens einer Raumachse zumindest teilweise elastisch ausgeführt ist; wobei die Prüfelementaufnahme in Wirkverbindung mit dem Ausgleichselement derart angeordnet ist, wobei das Prüfelement entlang der Raumachse elastisch beweglich ist. Die Erfindung betrifft auch ein Verfahren zur Prüfung mindestens eines Steckelements sowie die Herstellung eines Ausgleichelements in einer Vorrichtung zur Prüfung mindestens eines Steckelements.

## Beschreibung

### Technisches Gebiet

Die Erfindung betrifft eine Vorrichtung zur Prüfung mindestens eines Steckelements einer Steckverbindung. Die Erfindung betrifft zudem ein Verfahren zur Prüfung von Steckelementen einer Steckverbindung. Die Erfindung betrifft weiter die Verwendung eines erfindungsgemässen Ausgleichselements in einer Vorrichtung zur Prüfung von Steckelementen einer Steckverbindung. Die Erfindung betrifft zudem die Herstellung eines erfindungsgemässen Ausgleichselements zur Verwendung in einer Vorrichtung zur Prüfung von Steckelementen einer Steckverbindung.

### Stand der Technik

Steckverbindungen werden in einer Vielzahl von Anwendungen verwendet. So sind Steckverbindungen in der Elektroindustrie als elektrische Steckverbindung bekannt, um elektrisch leitende Elemente miteinander zu verbinden und einen elektrischen Kontakt herzustellen. Steckverbindungen sind jedoch auch in anderen Bereichen bekannt, beispielsweise im Rohrleitungsbau, in welchem zwei Rohre durch zusammenstecken miteinander verbunden werden und eine durchgängige Rohleitung realisieren. Auch in der optischen Industrie sind Steckelemente bekannt, beispielsweise zum Verbinden von optischen Leitungen. Optische Leitungen sind beispielsweise sogenannte Glasfasern.

In der Elektroindustrie sind Verbindungenzwischen zwei Steckelementen, sogenannten Steckverbindungen, oft reversibel ausgeführt, wobei eine Steckverbindung aus zwei Steckelementen ausgeführt ist. Ein erstes Steckelement wird mit einem weiteren Steckelement durch Zusammenführen verbunden. Dieser Vorgang wird allgemein auch als stecken oder einstecken bezeichnet. Die Bezeichnung Steckelement wird im Folgenden derart verstanden, dass ein Steckelement mit einem entsprechenden weiteren Steckelement durch ein Zusammenführen von Steckelement und weiterem Steckelement eine Steckverbindung herstellt. Das Zusammenführen ist dabei im Allgemeinen eine lineare Bewegung.

Das Steckelement ist zur Herstellung einer Steckverbindung mit dem weiteren Steckelement passend ausgerichtet, wird dann passgenau zusammengeführt. Die Steckverbindung ist oftmals kraftschlüssig lösbar fixiert. Dies geschieht beispielsweise durch eine Federkraft welche das Steckelement auf das weitere Steckelement ausübt. Alternativ kann das weitere Steckelement eine Federkraft auf das Steckelement ausüben.

Zur Herstellung einer Steckverbindung muss daher eine Kraft aufgewendet werden, mit der das Steckelement in das weitere Steckelement gedrückt wird. Diese Kraft wird als Steckkraft bezeichnet.

Zum Lösen einer Steckverbindung muss eine Kraft aufgewendet werden, mit der das Steckelement aus dem weiteren Steckelement der Steckverbindung gezogen wird. Diese Kraft wird als Auszugskraft, Ausziehkraft oder Auszugkraft bezeichnet.

Die Steckkraft und Ausziehkraft sind je nach Anwendung unterschiedlich. Für Steckverbindungen, welche nicht mechanisch beansprucht werden, beispielsweise durch Beschleunigung der die Steckverbindung enthaltenden Baugruppe, sind niedrige Auszugskräfte von wenigen 100 mN (Millinewton) bekannt. Für mechanisch stark beanspruchte Steckverbindungen sind auch Auszugskräfte von mehreren 100 N (Newton) bekannt. Auszugskräfte sind auch als Teil von DIN EN 60512-1-100_2012 bekannt.

In der Fertigung von Steckverbindungen ist daher essenziell, dass die Steckkraft und Ausziehkraft für eine Steckverbindung nicht mehr als eine Steckkrafttoleranz oder Ausziehkrafttoleranz von einem Steckkraftsollwert oder Ausziehkraftsollwert abweichen.

Um hochqualitative Steckverbindungen zu gewährleisten, muss daher die Steckkraft und/oder Ausziehkraft für Steckverbindungen überprüft werden. Dazu wird ein Steckelement in ein weiteres Steckelement eingeführt und die Kraft ermittelt, welche zum Fügen der Steckverbindung auftritt. Die in dieser Prüfung der Steckverbindung ermittelte Kraft muss sich in einem vorab festgelegten Bereich befinden, die für eine hochqualitative Steckverbindung festgelegt sind.

Eine solche Prüfung ist aus EP0703646A2 bekannt. Ein Leitereinsteckende wird als Prüfelement mittels eines Greifers in eine Anschlussstelle als Steckelement eingesteckt. Der Greifer ist eine Prüfelementaufnahme. Die Prüfelementaufnahme ist auf einen Kraftaufnehmer montiert, welcher eine Steckkraft beim Fügen Steckverbindung ermittelt. Zur Überprüfung der Verbindung wird eine entgegengesetzt der Steckkraft wirkende Kraft bis zu einem Sollwert einer Leiterhaltekraft, kurz Haltekraft, aufgewandt, welche unterhalb der Ausziehkraftsollwert liegt. Löst sich die Steckverbindung nicht, entspricht die Steckverbindung den Anforderungen. Die Steckkraft und/oder Ausziehkraft zwischen Steckelement und Prüfelement wird geprüft. Im Folgenden ist der Begriff Steckelement für das zu prüfende Steckelement verwendet.

Ein Steckelement beziehungsweise Prüfelement kann weiblich oder männlich sein, wobei das entsprechende weitere Steckelement der Steckverbindung entsprechend männlich oder weiblich ist. Ein Steckelement kann auch geschlechtslos sein, wobei das weitere Steckelement der Steckverbindung entsprechend ebenso geschlechtslos ist.

Das männliche Steckelement einer Steckverbindung weist im Allgemeinen nach aussen weisende Kontaktstiften auf. Ein Kontaktstift ist oft auch als Pin bezeichnet. Das weibliche Steckelement weist im Allgemeinen nach innen weisende Kontaktöffnungen auf. Das männliche Steckelement ist allgemein auch als Stecker oder Einbaustecker bekannt. Das weibliche Steckelement ist allgemein auch als Buchse oder Kupplung bekannt.

Steckkraft und Ausziehkraft sind jeweils in einer Prüfachse definiert, entlang welcher die Steckverbindung gefügt oder gelöst wird. Zum Fügen oder Lösen einer Steckverbindung ist das Steckelement und das Prüfelements auf der Prüfachse angeordnet. Bei einem Versatz von Prüfelement oder Steckelement von der Prüfachse wird die Steckkraft nicht korrekt ermittelt.

Fügen oder Lösen einer Steckverbindung wird auch als Stecken einer Steckverbindung bezeichnet.

In der Fertigung von Steckverbindungen wird die Ausziehkraft und/oder Steckkraft des gefertigten Steckelements mit einem passenden Prüfelement zumindest stichprobenartig geprüft. Das Prüfelement weist vorab festgesetzten Dimensionen und Eigenschaften auf. So kann ein Verschleiss an Fertigungsmaschine und/oder Werkzeug oder eine fehlerhafte Einstellung der Maschine erkannt werden und ein Ausschuss von gefertigten Steckelementen vermieden werden, welche nicht innerhalb der Steckkrafttoleranz oder Ausziehkrafttoleranz des Steckkraftsollwerts oder Ausziehkraftsollwerts liegen.

Die Verwendung eines Kraftsensors zur Ermittlung einer Steckkraft ist bekannt. Nachteilig ist jedoch, dass Querkräfte, welche nicht koaxial der designierten Steckkraft oder Ausziehkraft auf den Kraftsensor wirken, die Messung der Steckkraft oder Ausziehkraft verfälschen. Querkräfte treten auf, wenn Steckelement und Prüfelement beim Stecken der Steckverbindung nicht passgenau ausgerichtet sind. Nicht passgenau kann ein Parallelversatz des Prüfelements oder des Steckelements von der Prüfachse sein.

Bei asymmetrischer Belastung des Steckelements ist die Steckkraft oder Ausziehkraft nicht fehlerfrei bestimmbar. Besteht ein Versatz zwischen Steckelement und Prüfelement senkrecht zur Prüfachse, so tritt beim Stecken der Steckverbindung eine bereits erwähnte Querkraft auf. Diese führt zu einem übermässigen Verbiegen auf einer Seite des Steckelements, während die andere Seite des Steckelements entsprechend weniger belastet ist. Dies führt zu einer geänderten Reibung und einem resultierenden geänderten Kraftaufwand beim Stecken der Steckverbindung. Ein Versatz zwischen Steckelement und Prüfelement führt zu einem veränderten Kraftaufwand, da das Federelement, welches üblicherweise Steckelement und Prüfelement kraftschlüssig durch eine Federkraft verbindet, oftmals nicht linear zur Auslenkung des Federelements ist. Im allgemeinen beträgt der lineare Federweg einer Buchse einen Bruchteil des Durchmessers eines Kontaktstiftes. Wird eine Seite des Steckkontakts oder Prüfelements auf Grund eines Versatzes mehr als den zulässigen Federweg ausgelenkt, so beeinflusst diese Auslenkung den Kraftaufwand beim Stecken der Steckverbindung. Der zulässige Federweg ist dadurch gegeben, dass die Federkraft der Feder weiterhin im linearen Bereich bleibt, mit F=d·a, mit F der Federkraft, a der Auslenkung und d der Federkonstante. Dieser Zusammenhang ist als Hookesches Gesetz bekannt.

Nicht passgenau kann auch eine Verkippung gegen die Prüfachse mindestens eines des Verbindungselements und Gegenelements sein. Hier treten auf Grund des Winkelfehlers ausser den Querkräften auch Axialkräfte auf, welche die Messung zusätzlich verfälschen.

Aufgabe der Erfindung ist es, den Einfluss von Störkräften auf die Ermittlung der Steckkraft und/oder Ausziehkraft zu verbessern. Eine weitere Aufgabe der Erfindung liegt im Ausgleich eines Versatzes zwischen Prüfelement und Steckelement.

### Darstellung der Erfindung

Die Aufgabe wird durch die Merkmale der unabhängigen Ansprüche gelöst.

Die Erfindung betrifft Vorrichtung zur Prüfung von mindestens einem Steckelement; mit einem Prüfelement, welches zur Prüfung in das Steckelement steckbar ist; mit einer Steckelementaufnahme in welcher ein Steckelement angeordnet ist; mit einer Prüfelementaufnahme in welcher das Prüfelement angeordnet ist; wobei die Steckelementaufnahme und die Prüfelementaufnahme entlang einer Prüfachse für das Stecken beweglich angeordnet sind; mit einem Kraftsensor, welcher eingerichtet ist eine Kraft beim Stecken entlang der Prüfachse zu ermitteln und als ein Kraftsignal bereitzustellen; dadurch gekennzeichnet, dass die Vorrichtung ein Ausgleichselement zum Ausgleich eines Versatzes zwischen Steckelement und Prüfelement aufweist; dass das Ausgleichselement in mindestens einer Raumachse zumindest teilweise elastisch ausgeführt ist; dass die Prüfelementaufnahme in Wirkverbindung mit dem Ausgleichselement derart angeordnet ist, dass das Prüfelement entlang der Raumachse elastisch beweglich ist.

Ein Steckelement wird mit einem Prüfelement geprüft. Zur Prüfung eines Steckelements ist das Steckelement in der Steckelementaufnahme angeordnet und mit einem Fixierelement fixiert. Das Fixierelement kann eine Feder sein, welche das Steckelement mittels Kraftschluss in der Steckelementaufnahme fixiert. Das Fixierelement kann auch eine Schraube sein, welche das Steckelement kraftschlüssig in der Steckelementaufnahme fixiert. In der Prüfelementaufnahme ist ein Prüfelement fixiert, welches geeignet ist mit dem Steckelement eine Steckverbindung zu bilden. Beispielsweise ist das Prüfelement stiftförmig ausgeführt, wenn das Steckelement als Buchse ausgeführt ist. Das Stecken einer Steckverbindung zwischen Steckelement und Prüfelement erfolgt entlang der Prüfachse. Im Idealfall ist das Prüfelement derart in der Prüfelementaufnahme angeordnet und das Steckelement derart in der Steckelementaufnahme angeordnet, dass Steckelement und Prüfelement koaxial angeordnet sind und zudem koaxial zur Prüfachse ausgerichtet sind, entlang derer Prüfelementaufnahme und Steckelementaufnahme beweglich sind. Eine Steckkraft kann in diesem Fall ohne störende Einflüsse ermittelt werden, da Steckelement und Prüfelement bestmöglich ausgerichtet sind. In der Praxis tritt jedoch immer ein Versatz oder eine Verkippung zwischen Steckelement und Prüfelement auf. Dieser Versatz beeinflusst die Ermittlung der Steckkraft und/oder Ausziehkraft derart, dass nicht die minimale Steckkraft und/oder Ausziehkraft ermittelt wird. So ist ein Vergleich zwischen der Steckkraft und Ausziehkraft verschiedener Steckelemente nicht möglich, da die Steckkraft vom Versatz abhängt, der sich bei jeder Fixierung eines Steckelements in der Steckelementaufnahme ändert. Das Ausgleichselement gleicht in diesem Fall den Versatz oder die Verkippung aus. Der Ausgleich erfolgt dadurch, dass das Ausgleichselement flexibel ausgeführt ist. Sind das Steckelement und das Prüfelement beim Stecken gegeneinander versetzt, so richten sie sich bei Kontakt koaxial aus, da die bei einer Verkippung oder einem Versatz auftretende Querkraft das Ausgleichselement entsprechend elastisch verformt. Der Versatz darf dabei jedoch nur so gross sein, dass die Steckelement und Prüfelement noch zusammenfügbar sind. Ein Versatz von mehr als dem halben Durchmesser des Steckelements oder des Prüfelements kann nicht ohne zusätzliche Massnahmen ausgeglichen werden.

Vorteilhafterweise ist eine Zeitspanne zwischen vollendeter Fertigung des Steckelements und der Prüfung des Steckelements nur wenige Sekunden bis Stunden. Entsprechen mehrere Steckkontakt den Anforderungen nicht, so besteht möglicherweise ein Problem bei der Fertigung, beispielsweise fehlerhafte Dimensionen des Steckkontakts oder eine falsche Materialwahl. Um das Problem bei der Fertigung schnell zu beben und fehlerhafte Steckkontakte zu vermeiden, ist eine möglichst geringe Zeitspanne zwischen wenigen Sekunden bis Minuten besonders Vorteilhaft.

Die Prüfung eines Steckelements mit einer erfindungsgemässen Vorrichtung zur Prüfung von Steckelementen umfasst die Schritte:
a) Die Prüfelementaufnahme wird auf einer Position der Prüfachse bereitgestellt;
b) die Steckelementaufnahme wird auf einer Position der Prüfachse bereitgestellt;
c) der Verstellmechanismus bewegt das Prüfelement entlang der Prüfachse zum Steckelement;
d) das Kraftsignal und das Distanzsignal werden kontinuierlich ermittelt;
e) beim Kontakt von Prüfelement und Steckelement steigt das Kraftsignal an; das Ausgleichselement gleicht eine Fehlstellung von Prüfelement und Steckelement aus und es wird die Steckkraft als Funktion des Kraftsignals über die Distanz ermittelt und bereitgestellt;
f) die Steckkraft wird bei einer vorbestimmten Sollstecktiefe mit einer Sollsteckkraft verglichen.

Ein Signal, insbesondere ein Kraftsignal ist eine zeitliche Abfolge von Kraftwerten. Ein Anstieg eines Kraftsignals ist dann gegeben, wenn sich der Kraftwert von einem Wert von Null auf einen endlichen Wert ändert. Ein endlicher Wert ist von Null beziehungsweise dem Nullpunkt verschieden, wenn er ein Rauschens des Kraftsignals übersteigt. Eine Bewegung des Prüfelements kann auf Grund der Trägen Masse des Prüfelements eine Kraft auf den Kraftsensor ausüben und damit ein Kraftsignal generieren, welches nahe dem Nullpunkt ist. Dies ist nicht als Anstieg des Kraftsignals verstanden. Entsprechend ist ein Abfall eines Kraftsignals dann gegeben, wenn sich der Kraftwert von einem endlichen Wert auf einen Wert von Null ändert.

Stimmt die Steckkraft nicht innerhalb einer Sollsteckkrafttoleranz mit der Sollsteckkraft überein, so wird das Steckelement als fehlerhaft aussortiert. Ein aussortiertes Steckelement wird auch als Ausschuss bezeichnet. Übersteigt der Ausschuss einen im Vorhinein festgesetzten Wert, so wird die Fertigungsanlage überprüft und gegebenenfalls justiert. Mit dem Verfahren lassen sich schnell und frühzeitig Probleme in der Fertigung von Steckelementen erkennen.

Mit dem Verfahren können alle gefertigten Steckelemente geprüft werden, oder es kann eine Teilmenge aller gefertigten Steckelemente geprüft werden.

In einer Ausführungsform des Verfahrens wird der elektrische Leitwert zwischen Prüfelement und Steckelement durch ein Leitwertmessgerät kontinuierlich als Funktion der Distanz ermittelt und bereitgestellt. Diese zusätzliche Information zum Leitwert ermöglicht es zu ermitteln, bei welcher Distanz Steckelement und Prüfelement in Kontakt sind. Zudem kann vorteilhafterweise ermittelt werden, ob der Leitwert innerhalb einer Leitwerttoleranz liegt. Ist der Leitwert nicht innerhalb der Leitwerttoleranz, so kann dies auf ein Problem in der Fertigung des Steckkontakts hindeutet. Dies kann beispielsweise und nicht in abschliessender Aufzählung eine Verschmutzung des Steckelements, eine nicht ausreichende Reinigung des Steckelements, eine Korrosion des Steckelements sein. Eine unzureichende Steckkraft kann ebenfalls Ursache für einen unzureichenden Leitwert sein und kann direkt am Kraftsignal erkannt werden.

### Kurze Beschreibung der Zeichnungen

Im Folgenden wird die Erfindung beispielhaft unter Beizug der Figuren näher erklärt. Es zeigen
Fig. 1 eine schematische Teilansicht einer Ausführungsform Vorrichtung zur Prüfung von Steckelementen einer Steckverbindung,
Fig. 2 eine schematische Teilansicht einer weitere Ausführungsform Vorrichtung zur Prüfung von Steckelementen einer Steckverbindung,
Fig. 3 eine schematische Teilansicht einer Ausführungsform eines Ausgleichselements,
Fig. 4 eine weitere schematische Teilansicht einer Ausführungsform eines Ausgleichselements,
Fig. 5 eine weitere schematische Teilansicht einer Ausführungsform eines Ausgleichselements mit Kraftsensor und Prüfelement,
Fig. 6 eine weitere schematische Teilansicht einer weiteren Ausführungsform eines Ausgleichselements mit Kraftsensor und Prüfelement,
Fig. 7 eine schematische Darstellung des Kraftsignals beim Fügen und Lösen einer Steckverbindung;
Fig. 8 eine schematische Teilansicht einer weitere Ausführungsform Vorrichtung zur Prüfung von Steckelementen einer Steckverbindung mit Bereitstellmechanismus zur Bewegung der Steckelementaufnahme,
Fig. 9 eine schematische Teilansicht einer Ausführungsform eines Ausgleichselements,
Fig. 10 eine schematische Teilansicht einer Ausführungsform eines Ausgleichselements.

### Wege zur Ausführung der Erfindung

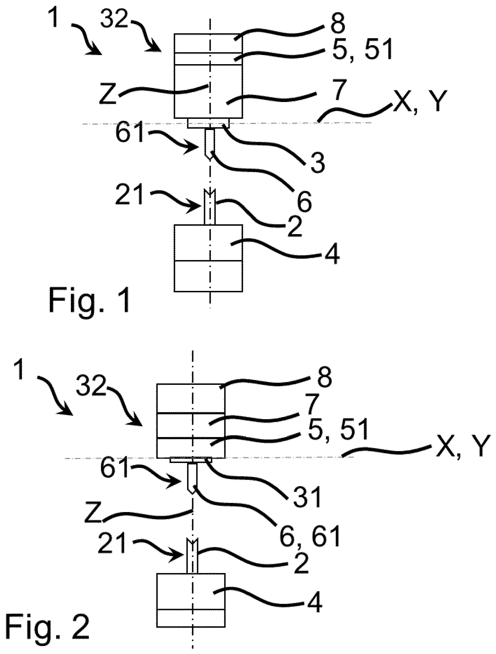

Fig. 1 zeigt eine Vorrichtung 1 zur Prüfung mindestens eines Steckelements 2. Die Vorrichtung 1 weist eine Steckelementaufnahme 4 für mindestens ein Steckelement 2 auf. Die Vorrichtung 1 weist mindestens eine Prüfelementaufnahme 3 für mindestens ein Prüfelement 6 auf. Die Prüfelementaufnahme 3 und die Steckelementaufnahme 4 sind entlang einer Prüfachse Z angeordnet. Die Prüfelementaufnahme 3 und die Steckelementaufnahme 4 sind entlang der Prüfachse Z gegeneinander beweglich. Die Bewegung von Prüfelementaufnahme 3 und Steckelementaufnahme 4 ist entlang der Prüfachse aufeinander zu oder voneinander weg möglich, sodass eine Distanz 9 zwischen Prüfelementaufnahme 3 und Steckelementaufnahme 4 sich vergrössert oder verkleinert.

Es sind jedoch auch Bewegungen zwischen Prüfelementaufnahme 3 und Steckelementaufnahme 4 denkbar, welche zueinander zumindest für kurze Steckwege auch bogenförmig oder anders geformt gestaltet sein können.

Eine Steckelementaufnahme 4 nimmt ein zu prüfendes Steckelement 2 auf und fixiert das Steckelement 2 in der Steckelementaufnahme 4. Nach erfolgter Prüfung kann das Steckelement 2 wieder entfernt werden. Die Fixierung ist daher reversibel ausgestaltet. Die Fixierung kann kraftschlüssig, beispielsweise durch eine Befestigungselement oder ein Klemmelement, ausgeführt sein. Ein Befestigungselement beispielsweise eine Schraube oder eine Mutter. Ein Klemmelement ist beispielsweise eine Feder oder ein Gummi. Die Fixierung kann auch formschlüssig erfolgen. Eine formschlüssige Fixierung kann ein Splint sein, der in eine entsprechende Ausnehmung eingreift. Die Fixierung fixiert in einer Ausführungsform das Steckelement 2 und widersteht einer höheren Kraft als das 1.5-fache der Sollauszugkraft.

Eine Prüfelementaufnahme 3 nimmt das Prüfelement 6 auf und fixiert das Prüfelement 6 in der Prüfelementaufnahme 3. Nach erfolgter Prüfung eines Steckelements 2 mit dem Prüfelement 6 verbleibt das Prüfelement 6 in der Prüfelementaufnahme, um ein nächstes Steckelement 2 prüfen zu können. Die Fixierung des Prüfelements 6 ist reversibel ausgestaltet. So kann das Prüfelement 6 bei Bedarf getauscht werden, beispielsweise wenn eine andere Art von Steckelementen geprüft werden soll. Die Fixierung des Prüfelements 6 kann kraftschlüssig, beispielsweise durch ein Befestigungselement oder ein Klemmelement, ausgeführt sein. Ein Befestigungselement beispielsweise eine Schraube oder eine Mutter. Ein Klemmelement ist beispielsweise eine Feder oder ein Gummi. Die Fixierung des Prüfelements 6 kann auch formschlüssig erfolgen. Eine formschlüssige Fixierung kann ein Splint sein, der in eine entsprechende Ausnehmung eingreift. Die Fixierung fixiert in einer Ausführungsform das Prüfelement 6 und widersteht einer höheren Kraft als das 1.5-fache der Sollauszugkraft.

Die Vorrichtung 1 weist einen Kraftsensor 5 auf, welcher eingerichtet ist eine Kraft 50 beim Stecken entlang der Prüfachse Z zu ermitteln und als ein Kraftsignal 51 bereitzustellen. Dies ist beispielsweise ein Kraftsensor 5, welcher eine Kraft mindestens entlang einer Achse ermittelt. Es sind verschiedene Ausführungsformen von Kraftsensoren 5 bekannt. Kraftsensoren 5 können eine Kraft über eine geometrische Änderung mindestens eines Dehnungsmessstreifens ermitteln. Ein möglicher Kraftsensor 5 auf Basis von Dehnungsmesstreifen ist in der Serie Kistler Typ 4576A erhältlich. Es existieren auch Kraftsensoren 5 mit piezoelektrischen Messelementen. Diese sind besonders geeignet kleine dynamische Kräfte zu ermitteln, wie sie in einem Steckvorgang auftreten können. Piezoelektrische Kraftsensoren 5 werden mit einer Vorspannkraft vorgespannt verwendet, um Zugkräfte und Drucckräfte ermitteln zu können. Ein Beispiel für einen piezoelektrischen Kraftsensor 5 ist der Kistler Typ 9001C oder Typ 9217A. Eine Ausziehkraft 54 wird als ein Zugkraft ermittelt. Eine Steckkraft 52 wird als eine Druckkraft ermittelt.

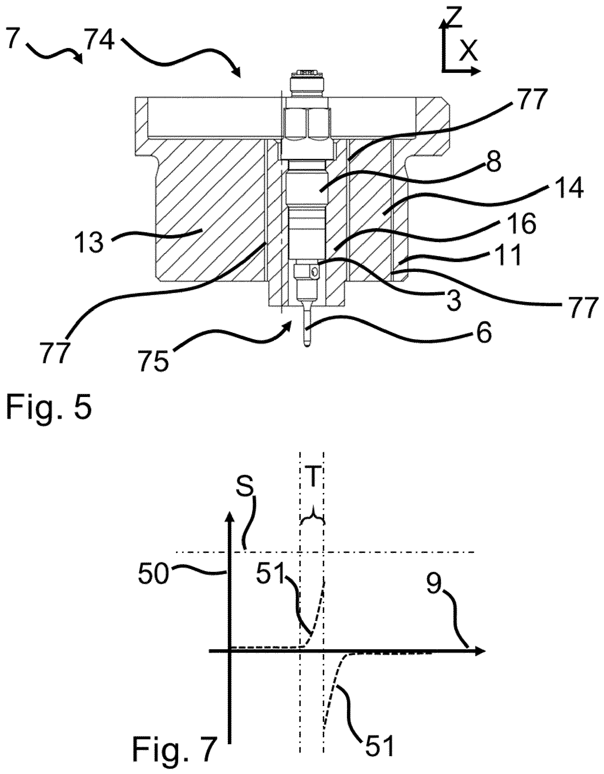

Der Kraftsensor 5 ist eingerichtet eine Kraft entlang der Prüfachse Z zu ermitteln und als Kraftsignal 51 bereitzustellen. Das Kraftsignal 51 weist während des Fügens der Steckverbindung aus Steckelement 2 und Prüfelement 6 die Steckkraft 52 auf. Das Kraftsignal 51 weist während des Lösens der Steckverbindung aus Steckelement 2 und Prüfelement 6 die Auszugkraft auf. Es ist vorteilhaft die Kraft ausschliesslich entlang der Prüfachse zu ermitteln. Es gibt zwar Kraftsensoren, die Kräfte auch in mehr als einer Achse ermitteln können, diese sind jedoch teurer als vergleichbar sensitive Kraftsensoren, welche die Kraft nur in einer Achse ermitteln. Ein Kraftsignal ist beispielhaft schematisch in Fig. 7 dargestellt.

Die Vorrichtung 1 weist erfindungsgemäss ein Ausgleichselement 7 zum Ausgleich eines Versatzes zwischen Steckelement 2 und Prüfelement 6 auf. Das Ausgleichselement 7 ist in mindestens einer Raumachse X zumindest teilweise elastisch ausgeführt. Die Prüfelementaufnahme 3 ist in Wirkverbindung mit dem Ausgleichselement 7 derart angeordnet, dass das Prüfelement 6 entlang der mindestens einer Raumachse X elastisch beweglich ist. Prüfelement 6 und Steckelement 2 sind derart fixiert, dass das Prüfelement 6 und das Steckelement 2 weitgehend auf der Prüfachse Z angeordnet sind. Weitgehend auf der Prüfachse Z ist derart zu verstehen, dass das Fügen einer Steckverbindung zwischen Prüfelement 6 und Steckelement 2 bei einer Bewegung von Prüfelementaufnahme 3 und Steckelementaufnahme 4 entlang der Prüfachse möglich ist. Selbstverständlich ist das Prüfelement 6 geeignet mit dem Steckelement 2 eine Steckverbindung 23 zu bilden. Ein Versatz von Steckelement 2 und Prüfelement 6 gegeneinander beeinflusst die Ermittlung der Steckkraft 52 und/oder Ausziehkraft 54 derart, dass nicht die minimale Steckkraft 52 und/oder Ausziehkraft 54 ermittelt wird. Die minimale Steckkraft 52 und/oder Ausziehkraft 54 ist die zu ermittelnde, relevante Grösse. Besteht ein Versatz, so ist ein Vergleich zwischen der Steckkraft 52 oder Auszugskraft 52 verschiedener Steckelemente 2 nicht möglich. Das Ausgleichselement 7 gleicht in diesem Fall den Versatz oder die Verkippung in mindestens einer Achse aus, wenn die Achse nicht parallel zur Prüfachse ist. Der Ausgleich erfolgt dadurch, dass das Ausgleichselement 7 flexibel in mindestens einer Achse ausgeführt ist, welche Achse nicht parallel zur Prüfachse ist. Sind das Steckelement 2 und das Prüfelement 6 gegeneinander versetzt oder verkippt, so richten sie sich beim Stecken koaxial aus, da die bei einer Verkippung oder einem Versatz auftretende Querkraft das Ausgleichselement 7 entsprechend elastisch in mindestens einer Achse X,Y verformt.

Wie in der Ausführungsform der Vorrichtung 1 in Fig. 2 schematisch dargestellt, kann der Kraftsensor 5 zwischen Prüfelement 6 und Ausgleichselement 7 angeordnet sein, wie in Fig. 5 dargestellt. Das Ausgleichselement 7 ist in Fig. 5 zur besserer Verständlichkeit der Anordnung als Schnittansicht dargestellt. Der Kraftsensor 5 ist hier gegen die Prüfachse Z entlang der mindestens einen Raumachse X elastisch beweglich durch die Flexibilität des Ausgleichselements 7 in mindestens einer Achse.

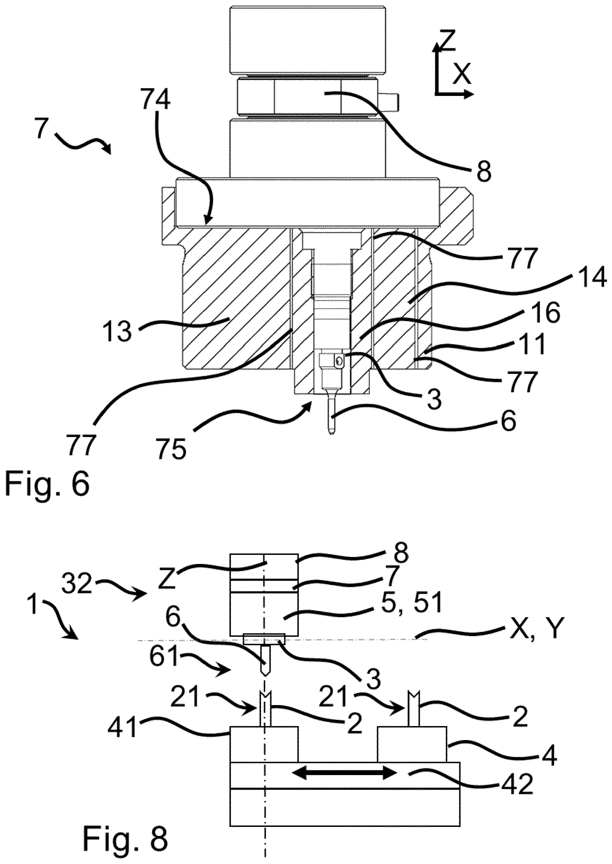

Alternativ kann der Kraftsensor 5 auf der dem Prüfelement 6 gegenüberliegenden Seite des Ausgleichselements 7 angeordnet sein, wie in der Ausführungsform der Vorrichtung 1 in Fig. 1 sowie in Fig. 6 schematisch dargestellt. Das Ausgleichselement 7 ist in Fig. 6 zur besserer Verständlichkeit als Schnittansicht dargestellt. In dieser Ausführungsform der Vorrichtung 1 ist der Kraftsensor 5 unbeweglich in einer Raumrichtung X,Y senkrecht zur Prüfachse Z angeordnet.

Der Kraftsensor 5 kann auch an einer anderen Position relativ zur Prüfteilaufnahme 3 angeordnet sein. Wichtig ist, dass der Kraftsensor im Kraftpfad angeordnet ist, in dem die Steckkraft 52 oder Ausziehkraft 54 messbar ist.

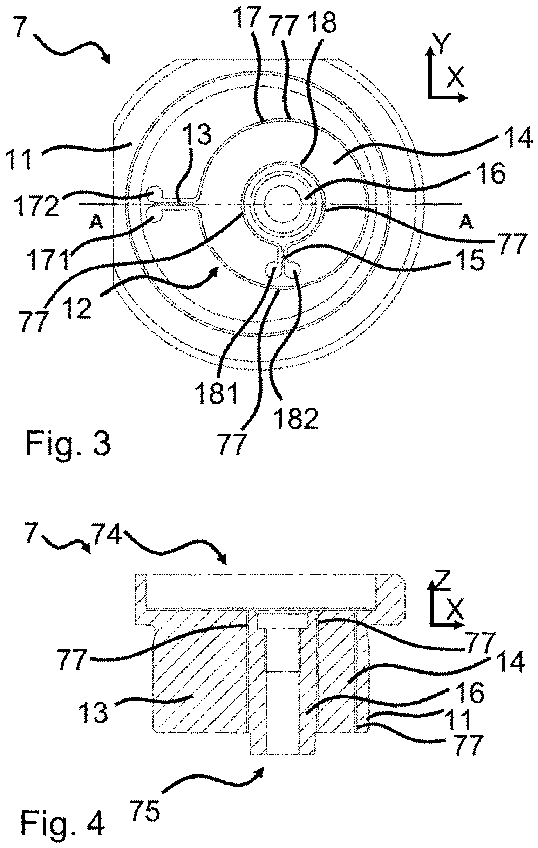

In einer Ausführungsform weist das Ausgleichselement 7 wie in Fig. 3 und Fig. 4 dargestellt einen äusseren Bereich 11 mit einer ersten Fläche 74 auf. Das Ausgleichselement 7 weist einen inneren Bereich 12 mit einer zweiten Fläche 75 auf.

Die erste Fläche 74 ist eingerichtet mit einem Körper 32 verbunden zu sein. Die zweite Fläche 75 ist eingerichtet mit einer Prüfelementaufnahme 3 verbunden zu sein, wie beispielhaft in Fig. 5 dargestellt.

Der innere Bereich 12 ist über mindestens ein Federelement 13 mit dem äusseren Bereich 11 verbunden. Die erste Fläche 74 ist im äusseren Bereich 11 angeordnet. Der innere Bereich 12 ist gegen den äusseren Bereich 11 reversible bewegbar. Durch die Beweglichkeit des inneren Bereichs 12 gegen den äusseren Bereich 11 ist das Ausgleichselement 7 elastisch ausgeführt. Alternativ kann die erste Fläche 74 auch kegelförmig oder halbkugelförmig oder dergleichen sein.

In einer Abwandlung der vorgenannten Ausführungsform des Ausgleichselements 7 weist der innere Bereich 12 einen ersten inneren Bereich 14 auf. Zudem weist das Ausgleichselement 7 einen zweiten inneren Bereich 16 auf. Der erste innere Bereich 14 ist über mindestens ein Federelement 15 mit dem zweiten inneren Bereich 16 verbunden. Der erste innere Bereich 14 ist gegen den zweiten inneren Bereich 16 bewegbar. Diese Teilung des Ausgleichelements 7 in äusserer Bereich 11, erster innerer Bereich 14 und zweiter innerer Bereich 16 ist vorteilhaft, da das Federelement 15 zwischen erstem inneren Bereich 14 und zweitem inneren Bereich 16 unabhängig vom Federelement 13 zwischen äusserem Bereich 11 und erstem inneren Bereich 14 ausführbar ist. So kann jedes Federelement 13,15 andere Eigenschaften bezüglich Federkraft und/oder bevorzugte Federachse als Bewegungsrichtung aufweisen. Die Federachse ist dabei die Achse, in der das Federelement 13,15 elastisch beweglich ausgeführt ist. Durch ein Federelement 13,15 verbundenen Bereiche sind hauptsächlich entlang der Federachse beweglich. In einigen Ausführungsformen eines Federelements 13,15 kann die Federachse eine Bogenform aufweisen.

Bevorzugt ist das Federelement 13,15 stegförmig ausgeführt. Das stegförmige Federelement 13,15 erstreckt sich zumindest teilweise zwischen der ersten Fläche 74 und der zweiten Fläche 75. Das Ausgleichselement 7 weist demnach eine Federkonstante 71 in Richtung der Prüfachse Z auf, welche mindestens um den Faktor zwanzig höher ist als die Federkonstante 72,73 des Ausgleichselements 7 in einer Richtung senkrecht zur Prüfachse Z. Dies hat den Vorteil, dass das stegförmige Federelement 13,15 in Richtung senkrecht zur Prüfachse Z elastisch ist und der innere Bereich 12 gegen den äusseren Bereich 11 senkrecht zur Prüfachse Z elastisch beweglich ist, während die Federkonstante 71 in Richtung der Prüfachse Z im Vergleich starr ausgeführt ist und der innere Bereich 12 nicht oder nur geringfügig gegen den äusseren Bereich 11 elastisch beweglich ist. Unter geringfügig elastisch beweglich wird verstanden, dass das Ausgleichselement 7 in Richtung der Prüfachse Z eine mindestens um den Faktor zwanzig höhere Federkonstante 71 aufweist als in einer Richtung senkrecht zur Prüfachse Z. Das Ausgleichselement 7 weist durch das Federelement 13,15 eine Federkonstante 72,73 entlang der Richtung senkrecht zur Prüfachse Z auf, entlang derer das Federelement 13,15 elastisch beweglich ist. In der in Fig. 3 gezeigten Ausführungsform ist die Federachse leicht bogenförmig. Da es sich jedoch um geringe Auslenkungen des Federelements 13,15 handelt, wird im Folgenden weiter der Begriff Federachse bzw. Raumachse verwendet, wenn die Auslenkung eines Federelements 13,15 beschrieben ist. Dies ist vorteilhaft, da in Richtung der Prüfachse Z ein Ausgleich des Versatzes von Steckelement 2 gegenüber dem Prüfelements 6 nicht notwendig ist. Es ist sogar vorteilhaft, wenn das Ausgleichselement 7 möglichst starr in Richtung der Prüfachse Z ausgeführt ist. Ansonsten würde beim Stecken der Steckverbindung zunächst das Ausgleichselement 7 gedehnt oder gestaucht, was eine unnötige zusätzliche Distanz 9 bei der Bewegung von Prüfteil 4 gegenüber Testteil 3 notwendig machen würde. Dies würde die Auswertung bzw. Beurteilung der Messung erschweren.

Ein Prüfelement 6 kann aus bereits gefertigten Steckelementen ausgewählt sein, welches Steckelement 2 mit einem bereits gefertigtem weiteren Steckelement 2 eine Steckkraft 52 aufweist, welche einer Sollsteckkraft 521 entspricht und/oder eine Ausziehkraft 54 aufweist, welche der Sollausziehkraft 541 entspricht. Es kann auch ein Prüfelement 6 speziell hergestellt sein und mit einem speziell zu diesem Zweck hergestellten weiteren Steckelement 2 eine Steckkraft 52 aufweisen, welche der Sollsteckkraft 521 entspricht und/oder eine Ausziehkraft 54 aufweisen, welche der Sollausziehkraft 541 entspricht. Es kann auch ein Prüfelement 6 eigens zu diesem Zweck hergestellt sein und mit einem bereits hergestellten weiteren Steckelement 2 eine Steckkraft 52 aufweisen, welche der Sollsteckkraft 521 entspricht und/oder eine Ausziehkraft aufweisen, welche der Sollausziehkraft 541 entspricht. Das Prüfelement 6 kann im Voraus festgelegten Dimensionen entsprechen und einen definierten Reibbeiwert aufweisen.

In einer Ausführungsform der Vorrichtung 1 ist das Ausgleichselement 7 in einer ersten Raumachse X elastisch beweglich. Die erste Raumachse X ist weitgehend senkrecht zur Prüfachse Z ausgerichtet. In dieser Ausführungsform der Vorrichtung ist zudem das Ausgleichselement 7 in einer zweiten Raumachse Y elastisch beweglich. Die zweite Raumachse Y ist weitgehend senkrecht zur Prüfachse Z ausgerichtet. Erste Raumachse X und zweite Raumachse Y sind nicht parallel. Vorteilhafterweise bilden die erste Raumachse X und die zweite Raumachse Y ein zweidimensionales, linear unabhängiges Koordinatensystem. Dies ist vorteilhaft, da der erste innere Bereich 14 gegen den äusseren Bereich 11 entlang der ersten Achse X senkrecht zur Prüfachse Z beweglich ist und der erste innere Bereich 14 gegen den zweiten inneren Bereich 16 entlang der zweiten Achse Y senkrecht zur Prüfachse Z und nicht parallel zur ersten Achse X beweglich ist. Äusserer Bereich 11 und zweiter innerer Bereich 16 sind so gegeneinander in diesem zweidimensionalen Koordinatensystem beweglich. Das bedeutet, dass ein Versatz des Steckelements 2 gegenüber dem Prüfelement 6, welches mit dem zweiten inneren Bereich 16 verbunden ist, durch das Ausgleichselement 7 ausgeglichen wird.

In einer besonders bevorzugten Ausführungsform der Vorrichtung 1 ist ein Winkel zwischen erster Raumachse X und zweiter Raumachse Y ein Winkel zwischen 45° und 135°. Besonders bevorzugt ist ein Winkel zwischen erster Raumachse X und zweiter Raumachse Y ein Winkel von 90°. In dieser Anordnung der Raumachsen ist die Federkraft, welche benötigt wird, um gegen die Federelemente 13,15 den zweiten inneren Bereich 16 gegen den äusseren Bereich 11 zu bewegen minimal im Vergleich zu einer nicht orthogonalen Anordnung der erstens Raumachse X und er zweiten Raumachse Y.

Das Ausgleichselement 7 ist bevorzugt zwischen der Prüfelementaufnahme 3 und einem Körper 32 angeordnet. Das Ausgleichselement 7 weist in Richtung der Prüfachse eine Federkonstante 71 auf. In Richtung der Prüfachse Z weist das Ausgleichselement 7 eine hohe Federkonstante 71 auf. Weist das Ausgleichselement 7 einen äusseren Bereich, einen ersten inneren Bereich 14 und einen zweiten inneren Bereich 16 auf, wobei der erste innere Bereich 14 gegen den äusseren Bereich 11 in einer ersten Achse beweglich ist und der zweite innere Bereich 16 gegen den ersten inneren Bereich 14 entlang einer zweiten Achse Y beweglich ist, so ist eine hohe Federkonstante auch gegeben, wenn das Ausgleichselement 7 in Richtung der ersten Raumachse X eine Federkonstante 72 aufweist, und wenn das Ausgleichselement 7 in Richtung der zweiten Raumachse Y eine Federkonstante 73 aufweist und die Federkontante 72 der ersten Raumachse X um mindestens den Faktor zwanzig kleiner ist als die Federkonstante 71 in Richtung der Prüfachse Z und die Federkontante 73 der zweiten Achse Y um mindestens den Faktor zwanzig kleiner ist als die Federkonstante 71 in Richtung der Prüfachse Z. Eine hohe Federkonstante 71 in Richtung der Prüfachse Z ist vorteilhaft, da beim Stecken der Steckverbindung das Ausgleichselement 7 nicht übermässig gedehnt oder gestaucht wird, was eine unnötige zusätzliche Distanz 9 bei der Bewegung von Prüfteil 4 gegenüber Testteil 3 verhindert.

Vorteilhafterweise ist das Ausgleichselement 7 aus einem Metall oder einer Metalllegierung ausgeführt. Das Ausgleichselement 7 ist durch den Ausgleich von Versätzen während jeder Messung mechanisch beansprucht. Daher eignen sich Metalle oder Metalllegierungen als Werkstoff für ein Ausgleichselement, da sie robust und haltbar sind. Besonders bevorzugt ist Aluminium als Material für das Ausgleichselement 7, da es einfach zu bearbeiten ist. Federelemente 13,15, beispielsweise in Form von Stegen, sind einfach aus Aluminium herstellbar und robust gegenüber mechanischer Belastung, insbesondere Wechsellast, wenn der Steg zur Bewegung von inneren Bereich 12 gegen äusseren Bereich 11 des Ausgleichelements 7 gebogen wird. Es sind jedoch auch andere Metalle oder Metalllegierungen wie beispielsweise Stähle oder Edelstähle als Material für das Ausgleichselement 7 möglich. So kann aus den Materialeigenschaften die Federkraft längs zur Prüfachse Z einfach für verschiedene Steckelemente 2 mit unterschiedlichen Steckkräften 52 angepasst werden.

In einer Ausführungsform ist das Ausgleichselement 7 aus Kunststoff ausgeführt. Dies hat den Vorteil, dass das Ausgleichselement 7 als Spritzgussteil schnell und kostengünstig herstellbar ist.

In einer Ausführungsform nimmt die Steckelementaufnahme 4 mindestens zwei Steckelemente 2 auf. Die Vorrichtung 1 weist dann einen Bereitstellmechanismus 42 zur Bewegung der Steckelementaufnahme 4 in mindestens einer Achse senkrecht zur Prüfachse auf. Der Bereitstellmechanismus 42 ist eingerichtet jeden der mindestens zwei Steckelemente 2 an einer Position 21 auf der Prüfachse bereitzustellen. So können mehrere Steckelemente 2 gleichzeitig in die Steckelementaufnahme 4 aufgenommen sein und hintereinander für jedes Steckelement 2 die Auszugkraft und/oder Steckkraft 52 ermittelt werden. Das spart Zeit, da die Vorrichtung 1 nicht für jede Messung eines Steckelemente 2 neu bestückt werden muss. Ein Bereitstellmechanismus 42 kann eine motorisierte Linearführung, ein Förderband, ein motorisierter zweiachsiger Verstelltisch oder motorisierter Kreuztisch sein. Der Bereitstellungsmechanismus 42 zur Bewegung der Steckelementaufnahme 4 kann auch als Rundtisch ausgeführt sein, wobei jedes der mindestens zwei Steckelemente 2 in einer Kreisbahn R senkrecht zur Prüfachse Z beweglich sind und der Bereitstellungsmechanismus 42 eingerichtet ist jedes der mindestens zwei Steckelemente 2 an einer Position 21 auf der Prüfachse Z bereitzustellen. Ein Bereitstellmechanismus 42 ist in Fig. 8 schematisch dargestellt.

In einer Ausführungsform der Vorrichtung 1 nimmt die Prüfelementaufnahme 3 mindestens zwei Prüfelemente 6 in einem Wechselmagazin auf. Das Wechselmagazin ist eingerichtet jedes der mindestens zwei Prüfelemente 6 an einer Position 61 auf der Prüfachse bereitzustellen. Dies ist vorteilhaft, da die Rüstzeit verkürzt wird wenn eine andere Bauform von Prüfelement 6 für eine korrespondierende Bauform von Steckelementen benötigt wird.

In einer alternativen Ausführungsform (nicht dargestellt) können Prüfelementaufnahme 3 und Prüfelement 6 einstückig ausgeführt sein In dieser Ausführungsform ist das vorher beschriebene Wechselmagazin nicht möglich.

Die Vorrichtung 1 weist bevorzugt einen Verstellmechanismus 8 auf. Die Prüfteilaufnahme 3 ist mit dem Verstellmechanismus 8 direkt oder indirekt fest oder reversibel lösbar verbunden. Der Verstellmechanismus 8 ist eingerichtet die Prüfteilaufnahme 3 entlang der Prüfachse Z zu bewegen, wobei die Distanz 9 zwischen Steckteilaufnahme 4 und der Prüfteilaufnahme 3 vergrössert oder verkleinert werden kann. Ein Verstellmechanismus 8 ist beispielsweise eine motorisierte Linearführung. Ein Beispiel für einen Verstellmechanismus 8 ist das Fügemodul Typ 2157B von Kistler. Ein Verstellmechanismus 8 hat den Vorteil, dass das Fügen und/oder Lösen von Prüfelement 6 und Steckelement 2 reproduzierbar in Geschwindigkeit und Richtung entlang der Prüfachse Z durchführbar ist. Insbesondere die Geschwindigkeit sollte für eine Prüfung eines Steckelements 2 üblicherweise 300 mm/s nicht überschreiten. Bei höheren Geschwindigkeiten kann das Aufprallen von Steckelement 2 auf Prüfelement 6 zu ungewollten Schwingungen im Kraftsensor 5 führen, welche die Messung verfälschen. Reibkräfte haben eine geschwindigkeitsabhängige Komponente. Daher sollte zur Vergleichbarkeit der Messungen immer eine vorab festgelegte Geschwindigkeit verwendet werden. Durch hohe Geschwindigkeiten oberhalb 300°mm/s werden Test- und Prüfkörper übermässig erwärmt, was ebenfalls zu Fehlmessungen führten kann. Der Verstellmechanismus 8 ist eingerichtet eine Distanz 9 der Bewegung entlang der Prüfachse zu ermitteln und als Distanzsignal 91 bereitzustellen. Dies ist vorteilhaft, da die Steckkraft 52 und/oder Ausziehkraft 54 in Abhängigkeit der Distanz 9 ermittelt werden können. So ist die Distanz 9 des Steckvorgangs bis zur Vollendung der Steckverbindung feststellbar und zwischen verschiedenen Steckelementen 2 vergleichbar. Eine fehlerhafte Länge eines Steckelements 2 ist so erkennbar, auch wenn das Steckelement 2 eine Steckkraft 52 und/oder Ausziehkraft 54 innerhalb der Steckkrafttoleranz oder Ausziehkrafttoleranz aufweisen sollte.

Vorteilhafterweise weist der Körper 32 den Verstellmechanismus 8 auf.

Ein Ausgleichselement 7 zur Verwendung in einer Vorrichtung 1 zur Prüfung von Steckelementen 2 wird bevorzugt in einem einfachen Fertigungsverfahren gefertigt. Das Ausgleichselement 7 weist eine erste Fläche 74 und eine zweite Fläche 75 auf. Das Ausgleichselement 7 ist aus einem einzelnen Materialstück gefertigt, beispielsweist Aluminium, ein anderes Metall oder eine Metalllegierung. Das Ausgleichselement 7 wird durch Entfernen von Material von dem Materialstück durch maschinelle Bearbeitung gefertigt, wobei das Entfernen von Material die folgenden Schritte umfasst:
- Entfernen von Material zwischen der ersten Fläche 74 und der zweiten Fläche 75 entlang einer Kurve derart, dass zwischen Anfangspunkt 171 der Kurve und Endpunkt 172 der Kurve 17 mindestens ein stegförmiges flexibles Federelement 13 gebildet wird und eine entstandene Ausnehmung zwischen erster und zweiter Fläche 75 mit dem Federelement 13 einen inneren Bereich mit einem äusseren Bereich 11 flexibel verbindet.
- Weiteres Entfernen von Material zwischen der ersten Fläche 74 und der zweiten Fläche 75 entlang einer Kurve 18 derart, dass zwischen Anfangspunkt 181 der Kurve 18 und Endpunkt 182 der Kurve 18 mindestens ein stegförmiges Federelement 15 bestehen bleibt und eine entstandene Ausnehmung zwischen erster und zweiter Fläche 75 mit dem stegförmigen Federelement 15 den inneren Bereich in einen ersten inneren Bereich 14 und einen zweiten inneren Bereich 16 teilt, wobei erster innerer Bereich 14 mit dem zweiten inneren Bereich 16 elastisch verbunden sind.

Material kann beispielsweise durch zerspanende Bearbeitung oder durch Drahterodieren entfernt werden.

Das Ausgleichselement 7 ist so einfach, kosteneffektiv und schnell fertigbar. Ausführungsformen eines Ausgleichelements sind in Fig. 3 bis Fig. 6 sowie Fig. 9 und Fig. 10 schematisch dargestellt.

In einer derzeit bevorzugten Ausführungsform des Ausgleichselements 7 weist das Ausgleichelement 7 mindestens einen Anschlag 77 auf. Ein Anschlag 77 begrenzt die Bewegung eines Federelements 13,15 in einer Richtung senkrecht zur Prüfachse Z. Dies ist Vorteilhaft, da ein Federelement 13,15 nur eine bestimmte Auslenkung eine Federkraft aufweist, welche linear zur Auslenkung ist. Das sogenannte Hookesche Gesetz, dass die Federkraft F gleich dem Produkt der Auslenkung a mit der Federkonstante d ist F = a·d, ist nur für eine vordefinierte Auslenkung gültig. Um zu grosse Auslenkungen des Inneren Bereichs 12 gegen den äusseren Bereich 11 des Ausgleichselements 7 zu verhindern, weist das Ausgleichselement 7 mindestens einen Anschlag 77 auf. Auch wird durch den Anschlag 77 eine übermässige Biegung des Federelements 13,15 verhindert. Eine übermässige Biegung ist dann vorhanden, wenn das Federelement 13,15 nach einer solchen Biegung eine irreversible Verformung des Federelements 13,15 aufweist. Ein Anschlag 77 ist beispielsweise eine Fläche, gegen die das Federelement 13,15 bei einer bestimmten Auslenkung anstösst. Ein Anschlag 77 in den Ausführungsformen eines Ausgleichselements in den Figuren 3, Fig. 9 und Fig. 10 beispielhaft dargestellt. Vorteilhafterweise weist das Ausgleichselement für jedes Federelement 13,15 jeweils mindestens einen Anschlag 77 auf. Besonders bevorzugt weist das Ausgleichselement für jedes Federelement 13,15 jeweils zwei Anschläge 77 auf, welche Anschläge die Bewegung des Federelements in beide Richtungen entlang der jeweiligen Raumachse X,Y begrenzen.

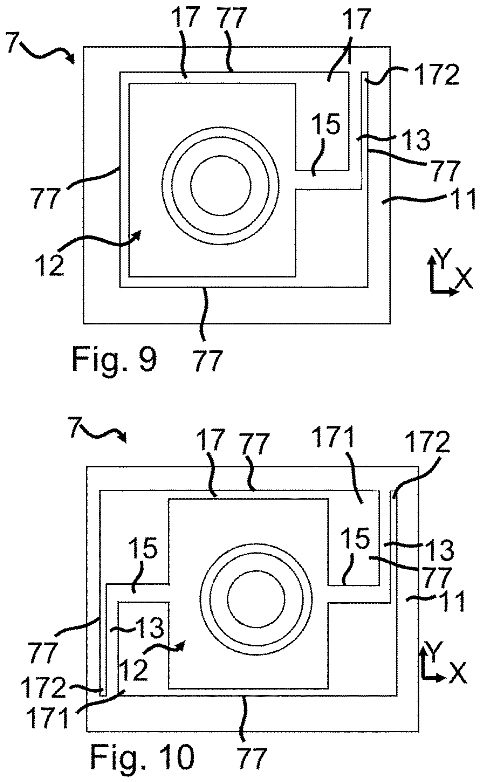

Eine weitere Ausführungsform eines Ausgleichselements 7 ist in Fig. 9 dargestellt. Das Ausgleichselement weist einen inneren Bereich 12 und einen äusseren Bereich 11 auf. Der innere Bereich 12 ist durch zwei Federelemente 13,15 mit dem äusseren Bereich elastisch verbunden. Ein erstes Federelement 13 ist elastisch entlang einer ersten Achse X ausgeführt. Ein zweites Federelement 15 ist elastisch entlang einer zweiten Achse Y ausgeführt. Wie in der Ausführungsform aus Fig. 3 sind die Federelemente 13,15 bevorzugt stegförmig ausgeführt.

Eine weitere Ausführungsform eines Ausgleichselements 7 ist in Fig. 10 dargestellt. Das Ausgleichselement weist einen inneren Bereich 12 und einen äusseren Bereich 11 auf. Der innere Bereich 12 ist durch zwei direkt miteinander verbundene Federelemente 13,15 mit dem äusseren Bereich elastisch verbunden. Ein erstes Federelement 13 ist elastisch entlang einer ersten Achse X ausgeführt. Ein zweites Federelement 15 ist elastisch entlang einer zweiten Achse Y ausgeführt. Zusätzlich ist der innere Bereich 12 mit mindestens zwei weiteren Federelementen 13,15 mit dem äusseren Bereich 11 elastisch verbunden wobei wiederum ein erstes Federelement 13 elastisch entlang der ersten Achse X ausgeführt ist und ein zweites Federelement 15 elastisch entlang der zweiten Achse Y ausgeführt ist. Diese Ausführungsform des Ausgleichselements 7 ist stabiler gengenüber der Ausführungsform aus Fig. 9. Bevorzugt sind in dieser Ausführungsform zwei Verbindungen von äusserem Bereich 11 und inneren Bereich 12 mit jeweils zwei Federelementen 13,15. Selbstverständlich sind aber auch mehr als zwei solcher Verbindungen denkbar.

In einer Ausführungsform ist der Kraftsensor 5 ein Mehrkomponentenkraftsensor, welcher zur Steckkraft entlang der Prüfachse Z zusätzlich mindestens eine Querkraft entlang einer ersten Raumachse X oder zweiten Raumachse Y und/oder mindestens ein Drehmoment ermittelt. Die Querkraft und/oder das Drehmoment werden als Zusatzkraftsignal bereitgestellt (nicht dargestellt). Das Zusatzkraftsignal kann als Qualitätsmerkmal herangezogen werden oder in die Berechnung der Steckkraft einbezogen werden oder zum Schutz der Messeinrichtung dienen.

Zur Prüfung von Steckelementen mit einer Vorrichtung 1 wird ein Verfahren verwendet, welches die Schritte aufweist:
a) Die Prüfelementaufnahme 3 wird auf einer Position 61 der Prüfachse bereitgestellt;
b) die Steckelementaufnahme 4 wird auf einer Position 21 der Prüfachse bereitgestellt;
c) der Verstellmechanismus 8 bewegt das Prüfelement 6 entlang der Prüfachse zum Steckelement 2;
d) das Kraftsignal 51 und das Distanzsignal 91 werden kontinuierlich ermittelt;
d1) optional wird der elektrische Leitwert zwischen Prüfelement 6 und Steckelement 2 durch ein Leitwertmessgerät kontinuierlich als Funktion der Distanz 9 ermittelt und bereitgestellt;
e) beim Kontakt von Prüfelement 6 und Steckelement 2 steigt das Kraftsignal 51 an; das Ausgleichselement 7 gleicht eine Fehlstellung von Prüfelement 6 und Steckelement 2 aus; es wird die Steckkraft 52 als Funktion des Kraftsignals 51 über die Distanz 9 ermittelt und bereitgestellt;
f) die Steckkraft 52 wird bei einer vorbestimmten Sollstecktiefe T mit einer Sollsteckkraft 521 verglichen

Stimmt die Steckkraft 52 nicht innerhalb einer Sollsteckkrafttoleranz mit der Sollsteckkraft 521 überein, so wird das Steckelement 2 als fehlerhaft aussortiert.

Das Verfahren zur Prüfung von Steckelementen mit einer Vorrichtung 1 weist in einer weiteren Ausführungsform des Verfahrens weitere zusätzliche Schritte auf, welche auf die Schritte a) bis g) folgen:
h) der Verstellmechanismus 8 bewegt das Prüfelement 6 entlang der Prüfachse weg vom Steckelement;
h1) optional wird das maximale Kraftsignal 51 ermittelt und als Haltekraft 53 bereitgestellt;
i)das Kraftsignal 51 als Funktion des Distanzsignal 91 wird kontinuierlich ermittelt und bis zu einem Abfall des Kraftsignals 51 bei Verlust des Kontakts zwischen Prüfelement 6 und Steckelement 2 als Auszugkraft ermittelt und bereitgestellt;
j)die Auszugkraft wird mit einer Sollauszugkraft verglichen;
j1)optional wird die Haltekraft 53 wird mit einer Sollhaltekraft 531 verglichen.

Stimmt die Ausziehkraft 54 in Schritt j) nicht innerhalb einer Sollausziehkrafttoleranz mit der Sollausziehkraft 541 überein, so wird das Steckelement 2 als fehlerhaft aussortiert.

Stimmt die Haltekraft 53 in optionalem Schritt j1) nicht innerhalb einer Sollhaltekrafttoleranz mit der Sollhaltekraft 531 überein, so wird das Steckelement 2 als fehlerhaft aussortiert.

In einer Ausführungsform des Verfahrens ist eine Sperrkraft S vorab festgelegt, wie in Fig. 7 dargestellt. Wird die Sperrkraft S vom Kraftsignal 51 erreicht, so wird jegliche Bewegung der Vorrichtung 1 gestoppt. Dies Gewährleistet, dass das Fügen des Prüfelements 6 in das Steckelement 2 vorschriftsmässig erfolgt. Wird das Prüfelement 6 zu weit in das Steckelement 2 gefügt, so gibt es einen natürlichen Anschlag, der nicht erreicht werden soll, da Steckelement 2 und/oder Prüfelement 6 Schaden nehmen könnten. Dies ist im Fall von einem Pin und einer Buchse als Prüfelement und Steckelement als "auf Block laufen" bekannt. Eine Beschädigung des Ausgleichselement 7 durch zu grosse Kräfte oberhalb der Sperrkraft S wird so vermieden.

Die Erfindung kann auch zur automatisierten Montage von Stiften in Stiftlöchern eingesetzt werden.

Die in dieser Schrift offenbarten Ausführungsformen der Vorrichtung 1 sind selbstverständlich miteinander kombinierbar. Es sind explizit in dieser Schrift auch Ausführungsformen einbezogen, welche eine Kombination der Merkmale hierin beschriebener Ausführungsformen aufweisen.

### Bezugszeichenliste

- 1: Vorrichtung
- 11: Äusserer Bereich
- 12: Innerer Bereich
- 13: Federelement
- 14: erster innerer Bereich
- 15: Federelement
- 16: Zweiter innerer Bereich
- 17: Kurve
- 171: Anfangspunkt
- 172: Endpunkt
- 18: Kurve
- 181: Anfangspunkt
- 182: Endpunkt
- 19: Leitwert
- 2: Steckelement
- 21: Position
- 3: Prüfelementaufnahme
- 32: Körper
- 4: Steckelementaufnahme
- 5: Kraftsensor
- 50: Kraft
- 51: Kraftsignal
- 52: Steckkraft
- 521: Sollsteckkraft
- 53: Haltekraft
- 531: Sollhaltekraft
- 54: Ausziehkraft
- 541: Sollausziehkraft
- 6: Prüfelement
- 61: Position
- 7: Ausgleichselement
- 71: Federkonstante entlang der Prüfachse
- 72: Federkonstante entlang der ersten Achse
- 73: Federkonstante entlang der zweiten Achse
- 74: Erste Fläche
- 75: Zweite Fläche
- 77: Anschlag
- 79: Materialstück
- 8: Verstellmechanismus
- 9: Distanz
- 91: Distanzsignal
- M: Leitwertmessgerät
- S: Sperrkraft
- T: Sollstecktiefe
- X: Raumachse, erste Raumachse
- Y: Raumachse, zweite Raumachse
- Z: Prüfachse

## Patentansprüche

1. Vorrichtung (1) zur Prüfung von mindestens einem Steckelement (2), mit einem Prüfelement (6), welches zur Prüfung in das Steckelement (2) steckbar ist; mit einer Steckelementaufnahme (4) in welcher ein Steckelement (2) angeordnet ist; mit einer Prüfelementaufnahme (3) in welcher das Prüfelement (6) angeordnet ist; wobei die Steckelementaufnahme (4) und die Prüfelementaufnahme (3) entlang einer Prüfachse (Z) für das Stecken beweglich angeordnet sind; mit einem Kraftsensor (5), welcher eingerichtet ist eine Kraft (50) beim Stecken entlang der Prüfachse (Z) zu ermitteln und als ein Kraftsignal (51) bereitzustellen; **dadurch gekennzeichnet, dass** die Vorrichtung (1) ein Ausgleichselement (7) zum Ausgleich eines Versatzes zwischen Steckelement (2) und Prüfelement (6) aufweist; dass das Ausgleichselement (7) in mindestens einer Raumachse (X,Y) zumindest teilweise elastisch ausgeführt ist; dass die Prüfelementaufnahme (3) in Wirkverbindung mit dem Ausgleichselement (7) derart angeordnet ist, dass das Prüfelement (6) entlang der Raumachse (X,Y) elastisch beweglich ist.

2. Vorrichtung (1) nach Anspruch 1, **dadurch gekennzeichnet, dass** das Prüfelement (6) reversibel fixierbar in der Prüfelementaufnahme (3) angeordnet ist; dass das Steckelement (2) reversibel fixierbar in der Steckelementaufnahme (4) angeordnet ist; und dass das Prüfelement (6) geeignet ist mit dem Steckelement (4) eine Steckverbindung (64) zu bilden.

3. Vorrichtung (1) nach einem der Ansprüche 1 oder 2, **dadurch gekennzeichnet, dass** das Ausgleichselement (7) in einer ersten Raumachse (X) elastisch beweglich ist; dass die erste Raumachse (X) weitgehend senkrecht zur Prüfachse (Z) ausgerichtet ist; **oder** dass das Ausgleichselement (7) in einer ersten Raumachse (X) und in einer zweiten Raumachse (Y) elastisch beweglich ist; dass die ersten Raumachse (X) und die zweite Raumachse (Y) weitgehend senkrecht zur Prüfachse (Z) ausgerichtet sind; und dass die erste Raumachse (X) und die zweite Raumachse (Y) ein zweidimensionales Koordinatensystem bilden.

4. Vorrichtung nach Anspruch 3, **dadurch gekennzeichnet, dass** die erste Raumachse (X) und die zweite Raumachse (Y) einen Winkel zwischen 45° und 135° bilden, bevorzugt einen Winkel von 90°.

5. Vorrichtung (1) nach Anspruch 3 oder 4, **dadurch gekennzeichnet, dass** das Ausgleichselement (7) zwischen der Prüfelementaufnahme (3) und einem Körper (32) angeordnet ist; dass das Ausgleichselement (7) in Richtung der Prüfachse (Z) eine Federkonstante (71) aufweist; dass das Ausgleichselement (7) in Richtung der ersten Achse (X) eine Federkonstante (72) aufweist; dass das Ausgleichselement (7) in Richtung der zweiten Achse (Y) eine Federkonstante (72) aufweist; dass die Federkontante (72) der ersten Achse (X) um den mindestens Faktor zwanzig kleiner ist als die Federkonstante (71) in Richtung der Prüfachse (Z); und dass die Federkontante (73) der zweiten Achse (Y) um mindestens den Faktor zwanzig kleiner ist als die Federkonstante (71) in Richtung der Prüfachse (Z).

6. Vorrichtung (1) nach einem der Ansprüche 1 bis 5, **dadurch gekennzeichnet, dass** die Steckelementaufnahme (4) mindestens zwei Steckelemente (2) aufnimmt; dass die Vorrichtung (1) einen Bereitstellmechanismus (42) zur Bewegung der Steckelementaufnahme (4) in mindestens einer Achse (X,Y) senkrecht zur Prüfachse (Z) aufweist; und dass der Bereitstellmechanismus (42) eingerichtet ist jeden der mindestens zwei Steckelemente (2) an einer Position (21) auf der Prüfachse (Z) bereitzustellen **und/oder** dass die Prüfelementaufnahme (3) mindestens zwei Prüfelemente (6) in einem Wechselmagazin (32) aufnimmt; und dass das Wechselmagazin (32) eingerichtet ist jedes der mindestens zwei Prüfelemente (6) an einer Position (61) auf der Prüfachse (Z) bereitzustellen.

7. Vorrichtung (1) nach einem der Ansprüche 1 bis 6, **dadurch gekennzeichnet, dass** die Vorrichtung (1) einen Verstellmechanismus (8) aufweist; dass der Verstellmechanismus (8) eingerichtet ist die Distanz (9) entlang der Prüfachse (Z) zwischen Prüfelementaufnahme (3) und Steckelementaufnahme (4) zum Stecken zu bewegen; und dass der Verstellmechanismus (8) eingerichtet ist eine Distanz (9) der Bewegung entlang der Prüfachse (Z) zu ermitteln und als Distanzsignal (91) bereitzustellen.

8. Vorrichtung 1 nach einem der vorgehenden Ansprüche, d**adurch gekennzeichnet,** dass das Ausgleichselement (7) einen äusseren Bereich (11) mit einer ersten Fläche (74) aufweist; dass das Ausgleichselement (7) einen inneren Bereich (12) mit einer zweite Fläche (75) aufweist; dass der innere Bereich (12) über mindestens ein Federelement (13,15) mit dem äusseren Bereich (11) verbunden ist; dass die erste Fläche (74) eingerichtet ist mit dem Verstellmechanismus (8) verbunden zu sein; dass die zweite Fläche (75) eingerichtet ist mit einer Prüfelementaufnahme (4) verbunden zu sein; und dass der innere Bereich (12) gegen den äusseren Bereich (11) elastisch bewegbar ist.

9. Vorrichtung (1) nach Anspruch 7 **dadurch gekennzeichnet, dass** der innere Bereich (12) einen ersten inneren Bereich (14) aufweist; dass der innere Bereich (12) einen zweiten inneren Bereich (16) aufweist; dass der erste innere Bereich (14) über mindestens ein Federelement (15) mit dem zweiten inneren Bereich (16) verbunden ist; und dass der erste innere Bereich (14) gegen den zweiten inneren Bereich (16) elastisch bewegbar ist.

10. Vorrichtung (1) nach einem der Ansprüche 8 oder 9, **dadurch gekennzeichnet, dass** das Ausgleichelement (7) mindestens einen Anschlag (77) aufweist; und dass ein Anschlag (77) die Bewegung des mindestens einen Federelements (13,15) in einer Raumrichtung (X,Y) senkrecht zur Prüfachse (Z) begrenzt.

11. Vorrichtung (1) nach einem der Ansprüche 8 bis 10, **dadurch gekennzeichnet, dass** das mindestens ein Federelement (13,15) stegförmig ausgeführt ist.

12. Vorrichtung nach einem der Ansprüche 1 bis 10, **dadurch gekennzeichnet, dass** das Ausgleichselement (7) aus einem Metall oder einer Metalllegierung ausgeführt ist.

13. Verfahren zur Herstellung eines Ausgleichselements (7) zur Verwendung in einer Vorrichtung (1) zur Prüfung von Steckelementen (2) nach einem der Ansprüche 1 bis 12, **dadurch gekennzeichnet, dass** das Ausgleichselement (7) eine erste Fläche (74) und eine zweite Fläche (75) aufweist; dass die erste Fläche (74) weitgehend parallel zur zweiten Fläche (75) ist; dass das Ausgleichselement (7) aus einem einzelnen Materialstück (79) gefertigt wird; dass das Ausgleichselement (7) durch Entfernen von Material von dem Materialstück (79) durch maschinelle Bearbeitung gefertigt wird, wobei das Entfernen von Material die folgenden Schritte umfasst:
- Entfernen von Material zwischen der ersten Fläche (74) und der zweiten Fläche (75) entlang einer Kurve (17) derart, dass zwischen Anfangspunkt (171) der Kurve (17) und Endpunkt (172) der Kurve (17) mindestens ein stegförmiges Federelement (13) gebildet wird und eine entstandene Ausnehmung (173) zwischen erster Fläche (74) und zweiter Fläche (75) mit dem Federelement (13) einen inneren Bereich (12) mit einem äusseren Bereich (11) flexibel verbindet;
- Weiteres Entfernen von Material zwischen der ersten Fläche (74) und der zweiten Fläche (75) entlang einer Kurve (18) derart, dass zwischen Anfangspunkt (181) der Kurve (18) und Endpunkt (182) der Kurve (18) mindestens ein stegförmiges Federelement (15) bestehen bleibt und eine entstandene Ausnehmung zwischen erster Fläche (74) und zweiter Fläche (75) mit dem stegförmigen Federelement (15) den inneren Bereich (12) in einen ersten inneren Bereich (14) und einen zweiten inneren Bereich (16) teilt, wobei erster innerer Bereich (14) mit dem zweiten inneren Bereich (16) elastisch verbunden sind.

14. Verfahren zur Prüfung von Steckelementen (2) mit einer Vorrichtung (1) nach Anspruch 8, **gekennzeichnet durch** die Schritte:
a) die Prüfelementaufnahme (3) wird auf einer Position (61) der Prüfachse (Z) bereitgestellt;
b) die Steckelementaufnahme (4) wird auf einer Position (21) der Prüfachse (Z) bereitgestellt;
c) der Verstellmechanismus (8) bewegt das Prüfelement (6) entlang der Prüfachse (Z) zum Steckelement (2);
d) das Kraftsignal (51) und das Distanzsignal (91) werden kontinuierlich ermittelt;
d1) optional wird ein elektrischer Leitwert (19) zwischen Prüfelement (6) und Steckelement (2) **durch** ein Leitwertmessgerät (M) kontinuierlich als Funktion der Distanz (9) ermittelt und bereitgestellt;
e) beim Kontakt von Prüfelement (6) und Steckelement (2) steigt das Kraftsignal an; das Ausgleichselement (7) gleicht eine Fehlstellung von Prüfelement (6) und Steckelement (2) aus; es wird eine Steckkraft (52) als Funktion des Kraftsignals (51) über das Distanzsignal (91) ermittelt und bereitgestellt;
f) die Steckkraft (52) wird bei einer vorbestimmten Sollstecktiefe (T) mit einer Sollsteckkraft (521) verglichen.

15. Verfahren zur Prüfung von Steckelementen (2) nach dem vorgehenden Anspruch, wobei die das Verfahren mit einer Vorrichtung (1) durchgeführt wird, **gekennzeichnet durch** die weiteren Schritte:
h) der Verstellmechanismus (8) bewegt das Prüfelement (6) entlang der Prüfachse (Z) weg vom Steckelement (2) ;
h1) optional wird das maximale Kraftsignal (51) ermittelt und als Haltekraft (53) bereitgestellt;
i)das Kraftsignal (51) als Funktion des Distanzsignal (91) wird kontinuierlich ermittelt und bis zu einem Abfall des Kraftsignals (51) bei Verlust des Kontakts zwischen Prüfelement (6) und Steckelement (2) als Ausziehkraft (54) ermittelt und bereitgestellt;
j)die Ausziehkraft (54) wird mit einer Sollausziehkraft (541) verglichen.
j1)optional wird die Haltekraft (53) wird mit einer Sollhaltekraft (531) verglichen.
